(19) Europäisches Patentamt

European Patent Office

Office européen des brevets

(11) Veröffentlichungsnummer: **0 226 255 B1**

(12) **EUROPÄISCHE PATENTSCHRIFT**

(45) Veröffentlichungstag der Patentschrift: **10.06.92**

(21) Anmeldenummer: **86202251.4**

(22) Anmeldetag: **12.12.86**

(51) Int. Cl.⁵: **H03C 1/54**

(54) **Modulator.**

(30) Priorität: **19.12.85 DE 3545006**

(43) Veröffentlichungstag der Anmeldung:
**24.06.87 Patentblatt 87/26**

(45) Bekanntmachung des Hinweises auf die
Patenterteilung:
**10.06.92 Patentblatt 92/24**

(84) Benannte Vertragsstaaten:
**AT DE FR GB NL**

(56) Entgegenhaltungen:
**EP-A- 0 040 274**
**EP-A- 0 051 179**
**GB-A- 2 120 032**

(73) Patentinhaber: **Philips Patentverwaltung GmbH**
**Wendenstrasse 35 Postfach 10 51 49**
**W-2000 Hamburg 1(DE)**

(84) Benannte Vertragsstaaten:
**DE**

(73) Patentinhaber: **N.V. Philips' Gloeilampenfa-brieken**
**Groenewoudseweg 1**
**NL-5621 BA Eindhoven(NL)**

(84) Benannte Vertragsstaaten:
**FR GB NL AT**

(72) Erfinder: **Matthies, Karl-Heinz**
**Tarfenbööm 14 g**
**W-2000 Hamburg 62(DE)**
Erfinder: **Bierkarre, Gert**
**Bundesstrasse 113**
**W-2050 Escheburg(DE)**

(74) Vertreter: **Hartmann, Heinrich, Dipl.-Ing. et al**
**Philips Patentverwaltung GmbH Wenden-strasse 35 Postfach 10 51 49**
**W-2000 Hamburg 1(DE)**

# Beschreibung

Die Erfindung betrifft einen Modulator mit
- einem ersten Differenzverstärker, der einen ersten Eingang zum Empfangen eines Eingangssignals und einen zweiten Eingang zum Empfangen eines Abgleichsignals zur Einstellung eines Ruhestroms an einem ersten und einem zweiten Ausgang des ersten Differenzverstärkers aufweist,
- einem zweiten und dritten Differenzverstärker, deren jeweiliger Steuereingang mit einem der beiden Ausgänge des ersten Differenzverstärkers gekoppelt ist und deren miteinander gekoppelte Differenzeingänge zum Empfangen eines Trägersignals und deren miteinander gekoppelte Differenzausgänge zum Abgeben eines modulierten Signals dienen, und
- einem Regelverstärker, dessen Eingang gekoppelt ist mit Mitteln zum wenigstens zeitweilig an diesem Eingang Zuführen eines dem Strom des ersten und dem Strom des zweiten Ausgangs des ersten Differenzverstärkers proportionalen Differenzsignals und dessen Ausgang über einen Speicher mit dem zweiten Eingang des ersten Differenzverstärkers gekoppelt ist.

Eine solche Schaltungsanordnung ist aus der europäischen Patentschrift 0 040 274 bekannt und kann z.B. in einem Videorecorder dazu verwendet werden, ein Farbartsignal bei der Aufzeichnung von einem höheren in ein niedrigeres Frequenzband oder bei der Wiedergabe von einem niedrigeren in ein höheres Frequenzband umzusetzen. Das Farbartsignal enthält zwei Signalanteile, das Farbsignal und das Farbsynchronsignal, die sich periodisch wiederholen und zwischen denen jeweils eine Signallücke auftritt.

Der erste Differenzverstärker enthält zwei Transistoren, deren Emitter mit einer Stromquelle gekoppelt sind. Der Basis des ersten Transistors wird das Eingangssignal und der Basis des zweiten Transistors ein Abgleichsignal zugeführt. Der Kollektor des ersten Transistors ist mit dem Emitter eines dritten und dem Emitter eines vierten Transistors, dem Steuereingang des zweiten Differenzverstärkers, und der Kollektor des zweiten Transistors ist mit dem Emitter eines fünften und dem Emitter eines sechsten Transistors, dem Steuereingang des dritten Differenzverstärkers, verbunden. Das Trägersignal wird zwischen der Basis des dritten und der Basis des vierten Transistors eingespeist (Differenzeingang des dritten Transistors). Die Basis des dritten und die des sechsten Transistors und die Basis des vierten und die des fünften sind miteinander verbunden. Das modulierte Signal wird den gekoppelten Differenzausgängen des zweiten und dritten Differenzverstärkers abgenommen, d.h. der Kollektor des dritten und der des fünften Transistors und der Kollektor des vierten und der des sechsten sind miteinander verbunden.

Für die Umsetzung eines Farbartsignals von einem niedrigeren in ein höheres Frequenzband ist es notwendig, daß der Ruhestrom des Kollektors des ersten und der des zweiten Transistors ungefähr gleich ist, um zu vermeiden, daß der Hilfsträger das Signal beeinflußt. Der Kollektorruhestrom des ersten oder zweiten Transistors ist der Strom, der fließt, wenn kein Eingangssignal anliegt.

Bei der bekannten Schaltungsanordnung werden die Ruheströme auf folgende Art abgeglichen. Der Steuereingang des zweiten Differenzverstärkers ist mit einem ersten Schalttransistor und der Steuereingang des dritten Differenzverstärkers mit einem zweiten Schalttransistor verbunden. Die beiden Schalttransistoren sind andererseits mit einem Regelverstärker verbunden, der über einen an Masse angeschlossenen Kondensator mit der Basis des zweiten Transistors gekoppelt ist. Der Differenzverstärker liefert ein Abgleichsignal zur Einstellung der Ruheströme. Die Schalttransistoren sind während des Auftretens der Horizontalimpulse geschlossen, da während dieser Zeit eine Signallücke beim Farbartsignal vorliegt. Um zu gewährleisten, daß die Schalttransistoren nur während des Auftretens der Horizontalimpulse leitend sind, ist zur Steuerung der Schalttransistoren eine Steuerschaltung notwendig.

Der Regelverstärker erzeugt nur während der Zeit in der die Horizontalimpulse auftreten ein Abgleichsignal, das im Kondensator gespeichert wird. Der Kondensator ist deshalb in der Regel so groß, daß er bei einer Realisierung des Modulators in einer integrierten Schaltung nicht mitintegriert werden kann.

Der Erfindung liegt die Aufgabe zugrunde, einen Modulator der eingangs genannten Art so auszubilden, daß eine Regelverstärkung ohne Steuerschaltung ständig durchgeführt wird.

Die Aufgabe wird erfindungsgemäß dadurch gelöst, daß die Mittel einen das Eingangssignal unterdrückenden Tiefpaß enthalten und dazu eingerichtet sind, das Differenzsignal ständig über diesen Tiefpaß dem Regelverstärker zuzuführen.

In dem erfindungsgemäßen Modulator unterdrückt der Tiefpaß die hochfrequenten Anteile des Differenzsignals, so daß dem Regelverstärker ein Gleichsignal zugeführt wird, das der Unsymmetrie der Ruheströme entspricht. Ist das Eingangssignal beispielsweise ein Farbartsignal, unterdrückt der Tiefpaß das hochfrequente Farbsynchronsignal und das hochfrequente Farbsignal. Dem Regelverstärker wird in diesem Fall ständig ein Gleichsignal zugeführt, das gleich dem Signal in der Signallücke des Farbartsignals ist. Der Regelverstärker erzeugt im Gegensatz zum Stand der Technik ständig ein Abgleichsignal, wodurch die Unsymmetrie der Ruheströme schneller ausgeglichen wird. Auch kann die Speicherkapazität durch die ständige Zuführung eines Abgleichsignals geringer sein.

Es sei noch erwähnt, daß aus der DE-PS 32 l3 506 eine Schaltungsanordnung bekannt ist, bei der ein Wechselspannungssignal mit Hilfe zweier parallel geschalteter Differenzverstärker verstärkt wird. Die Ausgänge der beiden Differenzverstärker sind mit zwei Transistoren verbunden, die ein verstärktes Wechselspannungssignal liefern. Dieses Ausgangssignal wird noch einer Regelschaltung zugeführt, die einen ersten und zweiten Tiefpaß enthält und die ein Regelsignal erzeugt, das dem Ausgang eines der parallel geschalteten Differenzverstärker zugeführt wird. Mit dieser Regelschaltung werden Gleichspannungswerte (Offset) im Ausgangssignal kompensiert. Bei dem vorliegenden erfindungsgemäßen Modulator ist es notwendig, die Kollekturruheströme am Ausgang des ersten Differenzverstärkers anzugleichen. Ein Gleichspannungswert (Offset) im Ausgangssignal des ersten Differenzverstärkers und im modulierten Signal muß nicht kompensiert werden. Außerdem wird dem Tiefpaß im erfindungsgemäßen Modulator das Ausgangssignal des ersten Differenzverstärkers zugeführt und nicht das Ausgangssignal des zweiten und dritten Differenzverstärkers, d.h. den beiden parallel geschalteten Differenzverstärkern.

Ein dem Strom des ersten und dem Strom des zweiten Ausgangs proportionales Differenzsignal wird erzeugt, indem der Steuereingang des zweiten und der Steuereingang des dritten Differenzverstärkers über jeweils einen Meßwiderstand mit einem der beiden an den Tiefpaß angeschlossenen Ausgänge des ersten Differenzverstärkers gekoppelt sind. Es ist auch möglich, ein proportionales Differenzsignal mit Hilfe zweier Stromspiegel zu gewinnen.

In einer Ausführungsform für den Tiefpaß ist vorgesehen, daß dieser einen vierten Differenzverstärker mit zwei Transistoren enthält, deren Basen über jeweils einen Widerstand mit dem Ausgang des ersten Differenzverstärkers verbunden sind, deren Basis-Kollektorstrecke jeweils ein Kondensator parallel geschaltet sind und deren Kollektoren den Ausgang des Tiefpasses bilden. Bei entsprechender Dimensionierung des Verstärkungsfaktors des vierten Differenzverstärkers und der Widerstände, können die Kondensatoren bei Realisierung des Modulators in einer integrierten Schaltungsanordnung mitintegriert werden. In einer Ausführungsform für den Regelverstärker ist vorgesehen, daß dieser einen das Ausgangssignal des Tiefpasses empfangenden fünften Differenzverstärker umfaßt, dessen Ausgang mit einem Stromspiegel gekoppelt ist.

Um einen Vorabgleich der Ruheströme zu ermöglichen, ist vorgesehen, daß der erste und zweite Eingang des ersten Differenzverstärkers über einen Spannungsteiler mit einer Referenzspannungsquelle gekoppelt ist. Der Spannungsteiler bewirkt eine Voreinstellung der Spannungen an den Eingängen des ersten Differenzverstärkers.

Um den Steuereingang des zweiten und den des dritten Differenzverstärkers vom Eingang des Tiefpasses zu entkoppeln, ist vorgesehen, daß der Steuereingang des zweiten und der Steuereingang des dritten Differenzverstärkers jeweils mit dem Kollektor eines Transistors verbunden sind, dessen Emitter mit einem der Ausgänge des ersten Differenzverstärkers gekoppelt ist und dessen Basis an einem Bezugspotential liegt.

In dem Modulator kann der Speicher ein an Masse angeschlossener Kondensator sein. Da das Abgleichsignal ständig vom Regelverstärker geliefert wird,ist der Kondensator auch viel kleiner als der in der bekannten Schaltungsanordnung. Es ist auch möglich, diesen auf einer integrierten Schaltung mit zu integrieren, wenn die Regelverstärkung entsprechend gewählt wird.

In einer Ausführungsform für den ersten Differenzverstärker enthält dieser einen Transistor, dessen Basis den ersten Eingang und dessen Kollektor den ersten Ausgang bildet und dessen Emitter mit dem Emitter eines weiteren im ersten Differenzverstärker enthaltenen Transistors gekoppelt ist, dessen Basis den zweiten Eingang und dessen Kollektor den zweiten Ausgang bildet.

In einer Ausführungsform für den zweiten und dritten Differenzverstärker umfassen diese jeweils zwei Transistoren, deren gekoppelte Emitter den Steuereingang, deren Basen den Differenzeingang und deren Kollektoren den Differenzausgang bilden.

Verwendet werden kann der Modulator in einem Fernsehempfänger oder Bildaufzeichnungs- und -wiedergabegerät (z.B. Videorecorder), wo er z.B. zur Umsetzung eines Farbartsignals in ein anderes Frequenzband dienen kann.

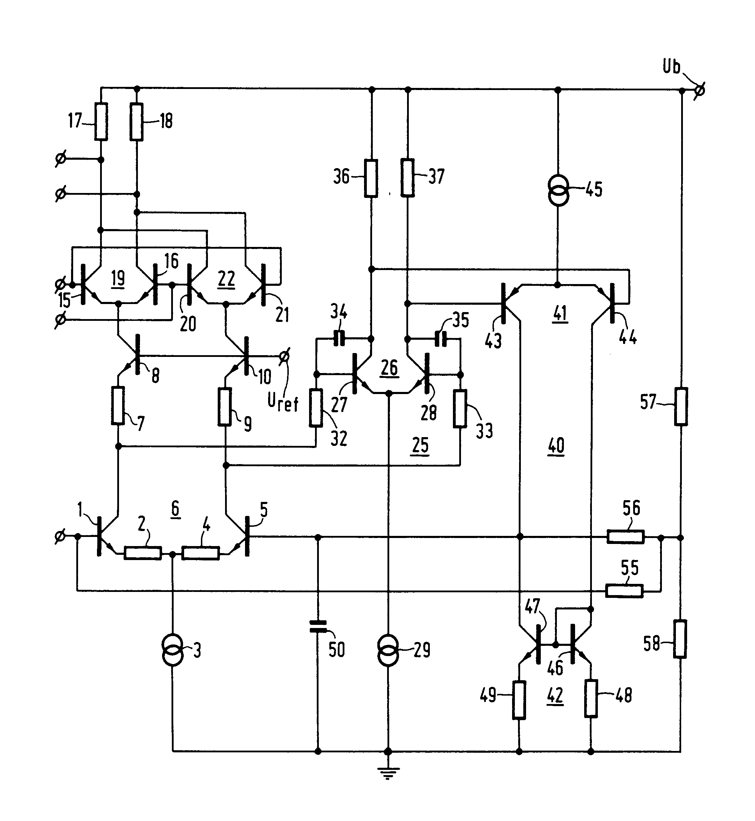

Anhand der Zeichnung wird im folgenden ein Ausführungsbeispiel der Erfindung erläutert.

Der in der Zeichnung dargestellte Modulator dient z.B. dazu, ein von einem Videorecorder wiedergegebenes Farbartsignal von einem ersten Träger mit einer Frequenz von 627 kHz auf einen zweiten Träger mit einer Freuenz von 4,43 MHz zu modulieren. Das Farbartsignal wird der Basis eines NPN-Transistors l zugeführt, dessen Emitter über einen Widerstand 2 einerseits mit einer an Masse geschalteten Stromquelle 3 und andererseits über einen Widerstand 4 mit dem Emitter eines NPN-Transistors 5 verbunden ist. Die Basis des Transistors l bildet einen Eingangsanschluß des ersten Eingangs eines die Transistoren l und 5 enthaltenden ersten Differenzverstärkers 6.

Der Kollektor des Transistors I ist über einen Meßwiderstand 7 an den Emitter eines NPN-Transistors 8 und der Kollektor des Transistors 5 über einen Meßwiderstand 9 an den Emitter eines NPN-Transistors I0 angeschlossen. Die beiden Meßwiderstände 7 und 9 sind gleich groß. Die Basis des Transistors 8 und die des Transistors I0 sind an eine niederohmige Spannungsquelle $U_{ref}$ angeschlossen. Der Kollektor des Transistors 8 ist mit dem Emitter eines NPN-Transistors I5 und mit dem Emitter eines NPN-Transistors I6 verbunden. Der Kollektor des Transistors I5 und der des Transistors I6 sind über jeweils einen Widerstand I7 bzw. I8 an eine Spannungsquelle Ub angeschlossen. Die Transistoren I5 und I6 bilden einen zweiten Differenzverstärker I9.

An den Verbindungspunkt zwischen dem Emitter eines NPN-Transistors 20 und dem Emitter eines NPN-Transistors 2I ist der Kollektor des Transistors I0 geschaltet. Die einen dritten Differenzverstärker 22 bildenden Transistoren 20 und 2I sind mit dem zweiten Differenzverstärker I9 auf folgende Weise gekoppelt. Zwischen dem ersten Eingangsanschluß, der durch die Basis des Transistors I5 und die Basis des Transistors 2I gebildet wird und dem zweiten Eingangsanschluß, der am Verbindungspunkt der Basis des Transistors I6 und der Basis des Transistors 20 liegt, wird ein Trägersignal mit einer Frequenz von 5,06 MHz zugeführt. Das modulierte Signal wird zwischen dem Kollektor des Transistors I5, der mit dem Kollektor des Transistors 20 verbunden ist, und dem Kollektor des Transistors I9, der mit dem Kollektor des Transistors 2I verbunden ist, abgenommen. Das modulierte Signal enthält das auf den Träger mit einer Frequenz von 4,43 MHz modulierte Farbartsignal. Durch die drei Differenzverstärker 6, I9 und 22 wird also ein an sich bekannter Vierquadranten-Multiplizierer gebildet. Die Transistoren 8 und I0 dienen zur Entkopplung des Differenzverstärkers 6 von den Differenzverstärkern I9 und 22.

Um Störungen bei der Bildwiedergabe zu verhindern, ist es erforderlich, daß der Kollektorruhestrom des Transistors I und der des Transistors 5 gleich sind. Da es nicht möglich ist, die Transistoren I und 5 vollkommen symmetrisch auszubilden, wird einem Eingangsanschluß des zweiten Eingangs des ersten Differenzverstärkers 6, das ist die Basis des Transistors 5, ein Abgleichsignal zur Einstellung der Ruheströme zugeführt.

An dem Meßwiderstand 7 wird eine dem Kollektorstrom des Transistors I und am Meßwiderstand 9 eine dem Kollektorstrom des Transistors 5 proportionale Spannung erzeugt. Die Differenz dieser Spannungen ist die Eingangsspannung für einen Tiefpaß 25. Der Tiefpaß 25 enthält einen vierten Differenzverstärker 26 mit einem NPN-Transistor 27 und einem NPN-Transistor 28. Die Basis des Transistors 27 ist über einen Widerstand 32 an den Kollektor des Transistors I und die Basis des Transistors 28 über einen Widerstand 33 an den Kollektor des Transistors 5 angeschlossen. Der Emitter des Transistors 27 und der Emitter des Transistors 28 sind mit einer an Masse angeschlossenen Stromquelle 29 verbunden. Der Basis-Kollektorstrecke des Transistors 27 ist ein Kondensator 34 und der Basis-Kollektorstrecke des Transistors 28 ist ein Kondensator 35 parallel geschaltet. Der Kollektor des Transistors 27 und der des Transistors 28 sind noch jeweils über Widerstände 36 bzw. 37 an die Spannungsquelle Ub angeschlossen. Das Ausgangssignal des Tiefpasses 25 ist zwischen dem Kollektor des Transistors 27 und dem des Transistors 28 abnehmbar. Der vierte Differenzverstärker 26 hat einen Verstärkungsfaktor von 6 bis 7 und die Widerstände 32 und 33 jeweils einen Widerstandswert von I0 kOhm. Die beiden Kondensatoren 34 und 35 haben eine Kapazität von 8 pF, so daß sie bei Realisierung des Modulators in einer integrierten Schaltung mitintegriert werden können. Der Tiefpaß 25 mit einer Grenzfrequenz von ungefähr 300 kHz unterdrückt das Farbartsignal und liefert am Ausgang ein der Differenz der Ruheströme entsprechendes proportionales Signal.

Das Ausgangssignal des Tiefpasses 25 wird einem Regelverstärker 40 zugeführt, der einen fünften Differenzverstärker 4I und einen Stromspiegel 42 umfaßt. Der Differenzverstärker 4I enthält einen PNP-Transistor 43, dessen Basis mit dem Kollektor des Transistors 28 verbunden ist, und einen PNP-Transistor 44, dessen Basis mit dem Kollektor des Transistors 27 verbunden ist. Der Emitter des Transistors 43 und der des Transistors 44 sind an eine mit der Spannungsquelle Ub verbundene Stromquelle 45 angeschlossen. Der Kollektor des Transistors 44 ist mit dem Kollektor eines NPN-Transistors 46 und mit dessen Basis und mit der Basis eines NPN-Transistors 47 verbunden. Außer den beiden Transistoren 46 und 47 enthält der Stromspiegel 42 einen Widerstand 48, der zwischen Masse und dem Emitter des Transistors 46 gelegt ist und einem Widerstand 49, der einerseits mit Masse und andererseits mit dem Emitter des Transistors 47 verbunden ist.

Der Kollektor des Transistors 43 und der Kollektor des Transistors 47 sind mit der Basis des Transistors 5 und einem an Masse angeschlossenen Kondensator 50 verbunden. Bei entsprechender Wahl des Verstärkungsfaktors des Differenzverstärkers 4I kann der Kondensator 50 mit einer Kapazität von I nF ebenfalls mitintegriert werden, da durch die ständige Zuführung eines Abgleichsignals der Kondensator viel kleiner ist als beim Stand der Technik. Am Verbindungspunkt des Kollektors des Transistors 43 und des Kollektors des Transistors 47 ist das Abgleichsignal für den zweiten Eingang des ersten Differenzverstärkers 6 abnehmbar.

Die Basis des Transistors I ist mit einem Widerstand 55 und die Basis des Transistors 5 mit einem Widerstand 56 verbunden, die gemeinsam an einen Spannungsteiler angeschlossen sind, der aus den Widerständen 57 und 58 besteht. Der Widerstand 57 ist noch an die Spannungsquelle Ub und der Widerstand 58 an Masse angeschlossen. Mit Hilfe der Widerstände 55 bis 58 kann ein Vorabgleich der Ruheströme ausgeführt werden.

**Patentansprüche**

1. Modulator, mit
   - einem ersten Differenzverstärker (6), der einen ersten Eingang zum Empfangen eines Eingangssignals und einen zweiten Eingang zum Empfangen eines Abgleichsignals zur Einstellung eines Ruhestroms an einem ersten und einem zweiten Ausgang des ersten Differenzverstärkers aufweist,
   - einem zweiten (I9) und dritten (22) Differenzverstärker, deren jeweiliger Steuereingang mit einem der beiden Ausgänge des ersten Differenzverstärkers gekoppelt ist und deren miteinander gekoppelte Differenzeingänge zum Empfangen eines Trägersignals und deren miteinander gekoppelte Differenzausgänge zum Abgeben eines modulierten Signals dienen, und
   - einem Regelverstärker (40), dessen Eingang gekoppelt ist mit Mitteln zum wenigstens zeitweiligen Zuführen an diesem Eingang eines dem Strom des ersten und dem Strom des zweiten Ausgangs des ersten Differenzverstärkers proportionalen Differenzsignals und dessen Ausgang über einen Speicher (50) mit dem zweiten Eingang des ersten Differenzverstärkers gekoppelt ist,
   dadurch gekennzeichnet, daß die Mittel einen das Eingangssignal unterdrückenden Tiefpaß (25) enthalten und dazu eingerichtet sind, das Differenzsignal ständig über diesen Tiefpaß dem Regelverstärker (40) zuzuführen.

2. Modulator nach Anspruch I,
   dadurch gekennzeichnet, daß der Steuereingang des zweiten (I9) und der Steuereingang des dritten Differenzverstärkers (22) über jeweils einen Meßwiderstand (7, 9) mit einem der beiden an den Tiefpaß (25) angeschlossenen Ausgänge des ersten Differenzverstärkers (6) gekoppelt sind.

3. Modulator nach einem der vorhergehenden Ansprüche,
   dadurch gekennzeichnet, daß der Tiefpaß (25) einen vierten Differenzverstärker (26) mit zwei Transistoren (27, 28) enthält, deren Basen über jeweils einen Widerstand (32, 33) mit dem Ausgang des ersten Differenzverstärkers (6) verbunden sind, deren Basis-Kollektorstrecke jeweils ein Kondensator (34, 35) parallelgeschaltet sind und deren Kollektoren den Ausgang des Tiefpasses (25) bilden.

4. Modulator nach einem der vorhergehenden Ansprüche,
   dadurch gekennzeichnet, daß der Regelverstärker (40) einen das Ausgangssignal des Tiefpasses (25) empfangenden fünften Differenzverstärker (4I) umfaßt, dessen Ausgang mit einem Stromspiegel (42) gekoppelt ist.

5. Modulator nach einem der vorhergehenden Ansprüche,
   dadurch gekennzeichnet, daß der erste und zweite Eingang des ersten Differenzverstärkers (6) über einen Spannungsteiler (57, 58) mit einer Referenzspannungsquelle (Ub) gekoppelt ist.

6. Modulator nach einem der vorhergehenden Ansprüche,
   dadurch gekennzeichnet, daß der Steuereingang des zweiten (I9) und der Steuereingang des dritten Differenzverstärkers (22) jeweils mit dem Kollektor eines Transistors (8, I0) verbunden sind, dessen Emitter mit einem der Ausgänge des ersten Differenzverstärkers (6) gekoppelt ist und dessen Basis an einem Bezugspotential liegt (Uref).

7. Modulator nach einem der vorhergehenden Ansprüche,
   dadurch gekennzeichnet, daß der Speicher ein an Masse angeschlossener Kondensator (50) ist.

8. Modulator nach einem der vorhergehenden Ansprüche,
   dadurch gekennzeichnet, daß der erste Differenzverstärker (6) einen Transistor (I) enthält, dessen Basis den ersten Eingang und dessen Kollektor den ersten Ausgang bildet und dessen Emitter mit dem Emitter eines weiteren im ersten Differenzverstärker enthaltenen Transistors (5) gekoppelt ist, dessen Basis den zweiten Eingang und dessen Kollektor den zweiten Ausgang bildet.

9. Modulator nach einem der vorhergehenden Ansprüche,
dadurch gekennzeichnet, daß der zweite (l9) und dritte Differenzverstärker (22) jeweils zwei Transistoren (l5, l6; 20, 2l) umfassen, deren gekoppelte Emitter den Steuereingang, deren Basen den Differenzeingang und deren Kollektoren den Differenzausgang bilden.

10. Verwendung eines Modulators nach einem der vorhergehenden Ansprüche, in einem Fernsehempfänger oder Bildaufzeichnungs- und -wiedergabegerät zur Modulation eines Farbartsignals.

**Claims**

1. Modulator comprising
   - a first differential amplifier (6) having a first input for receiving an input signal and a second input for receiving an adjusting signal for adjusting quiescent currents on first and second outputs of the first differential amplifier,
   - a second differential amplifier (19) and a third (22) differential amplifier, whose control inputs are each coupled to either output of the first differential amplifier and whose interconnected difference inputs are used for receiving a carrier signal and whose interconnected difference outputs are used for supplying a modulated signal, and
   - a control amplifier (40) whose input is coupled to means for at least temporarily applying to this input a difference signal which is proportional to the current on the first and the current on the second output of the first differential amplifier and whose output is coupled to the second input of the first differential amplifier by means of a storage device (50),
   characterized in that said means comprise a low-pass filter (25) rejecting the input signal and are arranged to supply the difference signal constantly to the control amplifier (40) by way of said low-pass filter.

2. Modulator as claimed in Claim 1, characterized in that by means of a current sensing resistor the control input of the second differential amplifier (19) and the control input of the third differential amplifier (22) are each coupled to either output of the first differential amplifier (6) which two outputs are connected to the low-pass filter (25).

3. Modulator as claimed in one of the preceding Claims, characterized in that the low-pass filter (25) comprises a fourth differential amplifier (26) which includes two transistors (27, 28) whose bases are connected to the output of the first differential amplifier (6) by way of a resistor (32, 33), whose base-collector junctions are each arranged in parallel with a capacitor (34, 35), and whose collectors constitute the output of the low-pass filter (25).

4. Modulator as claimed in one of the preceding Claims, characterized in that the control amplifier (40) comprises a fifth differential amplifier (41) which receives the output signal of the low-pass filter (25) and which has its output coupled to a current mirror circuit (42).

5. Modulator as claimed in any one of the preceding Claims, characterized in that the first input and the second input of the first differential amplifier (6) are coupled to a reference-voltage source by way of a voltage divider (57,58).

6. Modulator as claimed in one of the preceding Claims, characterized in that the control input of the second differential amplifier (19) and the control input of the third differential amplifier (22) are each connected to the collector of a transistor (8, 10) whose emitter is coupled to one of the outputs of the first differential amplifier (6) and whose base is at a reference potential $U_{ref}$.

7. Modulator as claimed in one of the preceding Claims, characterized in that the storage device is a capacitor (50) connected to earth.

8. Modulator as claimed in one of the preceding Claims, characterized in that the first differential amplifier (6) comprises a transistor (1) whose base constitutes the first input, whose collector constitutes the first output, and whose emitter is coupled to the emitter of a further transistor (5) of the first differential amplifier, the base of said further transistor constituting the second input and its collector constituting the second output.

9. Modulator as claimed in one of the preceding Claims, characterized in that the second differential amplifier (19) and the third differential amplifier (22) each comprise two transistors (15,16; 20, 21) whose coupled emitters constitute the control input, whose bases constitute the difference input, and whose collectors constitute the difference output.

10. Use of a modulator as claimed in one of the preceding Claims in a television receiver or video recording and/or reproducing apparatus for modulating a chrominance signal.

**Revendications**

1. Modulateur comprenant :
   - un premier amplificateur différentiel (6) qui comporte une première entrée pour la réception d'un signal d'entrée et une seconde entrée pour la réception d'un signal d'équilibrage en vue du réglage d'un courant de repos à une première et une seconde sortie du premier amplificateur différentiel,
   - un deuxième et un troisième amplificateur différentiel (19 et 22) dont chaque entrée de commande est couplée à une des deux sorties du premier amplificateur différentiel et dont les entrées de différence couplées l'une à l'autre sont destinées à la réception d'un signal porteur et les sorties de différence couplées l'une à l'autre sont destinées à la fourniture d'un signal modulé, et
   - un amplificateur de réglage (40) dont l'entrée est couplée à des moyens destinés à fournir, au moins temporairement à cette entrée, un signal de différence proportionnel au courant de la première sortie et au courant de la seconde sortie du premier amplificateur différentiel et dont la sortie est couplée, par l'intermédiaire d'un dispositif de stockage (50), à la seconde entrée du premier amplificateur différentiel,
   
   caractérisé en ce que :
   les moyens comprennent un filtre passe-bas (25) supprimant le signal d'entrée et sont agencés pour appliquer de manière continue le signal de différence par l'intermédiaire de ce filtre passe-bas à l'amplificateur de réglage (40).

2. Modulateur suivant la revendication 1, caractérisé en ce que l'entrée de commande du deuxième (19) et l'entrée de commande du troisième amplificateur différentiel (22) sont couplées chacune par l'intermédiaire d'une résistance de mesure (7,9) à une des deux sorties du premier amplificateur différentiel (6) connectées au filtre passe-bas (25).

3. Modulateur suivant l'une quelconque des revendications précédentes, caractérisé en ce que le filtre passe-bas (25) comprend un quatrième amplificateur différentiel (26) avec deux transistors (27,28) dont les bases sont connectées chacune, par l'intermédiaire d'une résistance (32, 33), à la sortie du premier amplificateur différentiel (6), dont les trajets base-collecteur sont connectés en parallèle chacun à un condensateur (34, 35) et dont les collecteurs forment la sortie du filtre passe-bas (25).

4. Modulateur suivant l'une quelconque des revendications précédentes, caractérisé en ce que l'amplificateur de réglage (40) comprend un cinquième amplificateur différentiel (41) recevant le signal de sortie du filtre passe-bas et dont la sortie est couplée à un miroir de courant (42).

5. Modulateur suivant l'une quelconque des revendications précédentes, caractérisé en ce que la première et la seconde entrée du premier amplificateur différentiel (6) sont couplées, par l'intermédiaire d'un diviseur de tension (57,58), à une source de tension de référence (Ub).

6. Modulateur suivant l'une quelconque des revendications précédentes, caractérisé en ce que l'entrée de commande du deuxième amplificateur différentiel (19) et l'entrée de commande du troisième amplificateur différentiel (22) sont connectées chacune au collecteur d'un transistor (8, 10) dont l'émetteur est couplé à une des sorties du premier amplificateur différentiel (6) et dont la base est à un potentiel de référence ($U_{ref}$).

7. Modulateur suivant l'une quelconque des revendications précédentes, caractérisé en ce que le dispositif de stockage est un condensateur (50) mis à la masse.

8. Modulateur suivant l'une quelconque des revendications précédentes, caractérisé en ce que le premier amplificateur différentiel (6) comprend un transistor (1) dont la base forme la première entrée et dont le collecteur forme la première sortie et dont l'émetteur est couplé à l'émetteur d'un autre transistor (5) contenu dans le premier amplificateur différentiel, la base de ce transistor formant la seconde entrée et son collecteur, la seconde sortie.

9. Modulateur suivant l'une quelconque des revendications précédentes, caractérisé en ce que le deuxième (19) et le troisième amplificateur différentiel (22) comprennent chacun deux transistors (15, 16; 20, 21) dont les émetteurs couplés forment l'entrée de commande, les bases, l'entrée de différence, et les collecteurs, la sortie de différence.

10. Utilisation d'un modulateur suivant l'une quelconque des revendications précédentes, dans un récepteur de télévision ou un appareil d'enregistrement et de reproduction vidéo, pour la modulation d'un signal de chrominance.